# EUROPEAN PATENT APPLICATION

(11) **EP 2 395 364 A1**
(43) Date of publication of application: **14.12.2011**
(21) Application number: 10165861.5
(22) Date of filing: 14.06.2010
(51) Int. Cl.: G01R 31/12, G01R 31/34, G01R 31/06, G01R 31/02

(54) **Method for detecting the partial discharges generated in an electric system and electric system with a device for detecting the partial discharges generated therein**

(71) Applicant: Alstom Technology Ltd, 5400 Baden (CH)
(72) Inventor: Behrmann, Glenn, 5400, Baden (CH)

(57) **Abstract**

The method for detecting the partial discharges generated in an electric system (1) comprises detecting at least a first signal (28) indicative of the partial discharges at a first location of the electric system (1), detecting at least a second signal (29) indicative of the partial discharges at a second location of the electric system (1), comparing the first and the second signals (28, 29) to ascertain whether a defect originating them is located within a rotating electric machine (3) or a bus duct (4) of the electric system (1).

## Description

### TECHNICAL FIELD

The present invention relates to a method for detecting the partial discharges generated in an electric system and an electric system with a device for detecting the partial discharges generated therein.

In particular the electric system includes at least a rotating electric machine (such as for example an electric generator or an electric motor).

### BACKGROUND OF THE INVENTION

In the following reference to electric systems comprising an electric generator connected to a bus duct, connecting the electric generator to an electric grid, is made.

It is anyhow clear that in different embodiments the rotating electric machine may also be an electric motor.

Rotating electric machines such as electric generators may have insulation having defects (for example in the insulating layers of the windings) that cause partial discharges during operation.

Defects are voids or delaminations or other such inhomogeneities in the insulation layers filled with gas, e.g. air or nitrogen or other by-products produced during the manufacturing process.

Partial discharges are the local discharges or breakdown within the insulation layers, with "partial" meaning that they are confined to only a part of the insulation layers or material (i.e. not being a total breakdown or flashover).

Partial discharges occur in the form of current pulses mainly confined within the defect and whose risetimes are very short (typically <1 nanosecond) depending on complex factors such as the pressure and composition of the gas within the defects in which they take place and which cannot be changed.

The partial discharge pulses generate radio frequency signals (also called partial discharge signals) containing components which extend up to several hundred Megahertz (VHF, UHF).

The partial discharge signals propagate away from the defects during which they undergo severe reflection, dispersion and damping effects via a plurality of mechanisms and paths which cannot be changed, such that the higher the frequency of these partial discharge signals, the stronger is the degradation due to these damping and dispersive effects.

Partial discharges can both indicate and cause degradation of the insulation by producing changes in the insulating qualities of adjacent materials or surfaces, often leading to further partial discharge activity, aging effects, and overall deterioration of the insulating layers, with the result that breakdown may eventually occur.

Thus partial discharges generated within a rotating machine (i.e. the electric generator) are to be avoided and therefore it is advantageous to detect them in order to mitigate their effects.

In addition, partial discharge may also occur in the bus duct.

Bus ducts comprise an inner current-carrying conductor surrounded by and supported within an earthed enclosure in a coaxial arrangement; partial discharges may for example be generated between the inner conductor and its supports or from other sources within the bus duct enclosure.

Partial discharges generated within the bus duct are generally not considered significant and therefore need not be mitigated.

Traditionally, in order to detect partial discharges in rotating electric machines, sensors are connected to the same rotating electric machine; for example a sensor may be connected to each of the three main power phase connections (main power output connections in the case of generators, main power input connection in the case of motors), in a zone close to a bus duct connection. These sensors are then connected to a measuring instrument to display and monitor the signals detected.

In case a defect exists in the rotating electric machine insulation or in the bus duct, it generates pulses and thus partial discharge signals that propagate throughout the electric system, reaching the sensors.

Nevertheless, some types of defects within the bus duct produce partial discharges whose signal characteristics are very similar to those originating within the rotating electric machine.

In particular, if partial discharges within the bus duct are of high amplitude, they may act to mask or become confused with signals of greater significance being sought, for example partial discharge signals within the rotating electric machine.

This makes it difficult to determine whether the defects causing the partial discharges are within the rotating electric machine (and thus must be accurately monitored and mitigated) or external to it (and thus are generally harmless and of minor interest and require no mitigation).

### SUMMARY OF THE INVENTION

The technical aim of the present invention is to provide a method and an electric system by which the said problems of the known art are eliminated.

Within the scope of this technical aim, an aspect of the invention is to provide a method and an electric system that allow determining whether the partial discharge signals are originating from within the bus duct or from within the rotating electric machine.

The technical aim, together with these and further aspects, are attained according to the invention by providing a method and electric system in accordance with the accompanying claims.

### BRIEF DESCRIPTION OF THE DRAWINGS

Further characteristics and advantages of the invention will be more apparent from the description of preferred but non-exclusive embodiments of the method and electric system, illustrated by way of non-limiting examples in the accompanying drawings, in which:
Figure 1 is a schematic view of an electric system in an embodiment of the invention;
Figure 2 is a schematic view of an electric system in a different embodiment of the invention;
Figure 3 is a schematic diagram showing possible signals detected by sensors of the electric system;
Figure 4 is a schematic longitudinal section of a bus duct (showing only one of the phases) with a sensor connected thereto.

### DETAILED DESCRIPTION OF EMBODIMENTS OF THE INVENTION

With reference to the figures, these show an electric system 1 with a device 2 for detecting the partial discharges generated therein.

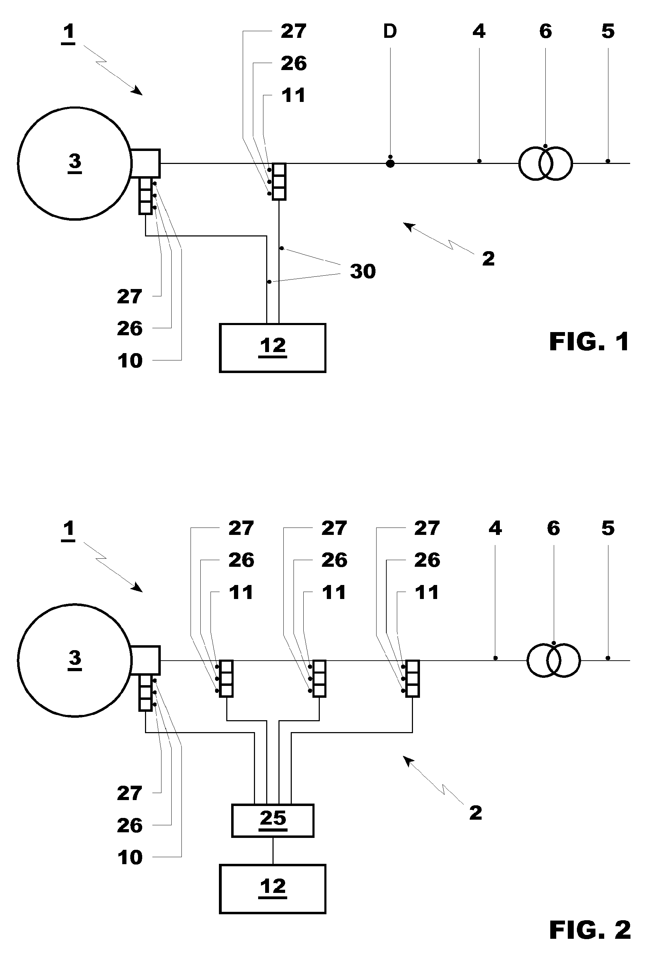

The electric system 1 comprises (figure 1) a rotating electric machine 3 such as an electric generator, connected to a bus duct 4 that, in turn, is connected to an electric grid 5 via a transformer 6.

Typically the bus duct 4 is directly connected at one end to the generator 3, and at the opposite end to the transformer 6.

The device 2 comprises first partial discharge sensors 10 arranged to detect first signals indicative of the partial discharges and positioned at first locations of the electric system 1; preferably the first locations are at the generator, i.e. they are in a zone between the output of the generator 3 and the end of the bus duct 4 connected thereto.

In particular the first sensors 10 are generally housed within a so-called "terminal cabinet" which is actually part of the overall generator housing to which the bus ducts are attached and from which they exit.

In addition, the device 2 also comprises second partial discharge sensors 11 arranged to detect second signals indicative of the partial discharges and connected at second locations of the electric system 1; the second locations are at the bus duct 4.

A measuring instrument 12 is connected to the first and second sensors 10, 11 via coaxial cables 30 and is arranged to compare first signals 28 from the first sensors 10 with second signals 29 from the second sensors 11, to ascertain whether the partial discharges originate within the generator 3 or the bus duct 4.

Preferably also an amplifier 26 and/or filter 27 are connected between the sensors 10, 11 and the measuring instrument 12.

In particular, each phase of the rotating electric machine and each phase of the bus duct 4 are equipped with sensors 10 and 11 (i.e. each phase of the electric system 1 has sensors 10, 11); in addition there may only be one measuring instrument 12 for all the phases or one for each phase.

Figure 2 shows a different embodiment with a plurality of second sensors 11 located at a plurality of second locations along the same phase of the bus duct 4.

Typically, sensors 10 are capacitive partial discharge couplers and sensors 11 are bus duct radio frequency sensors.

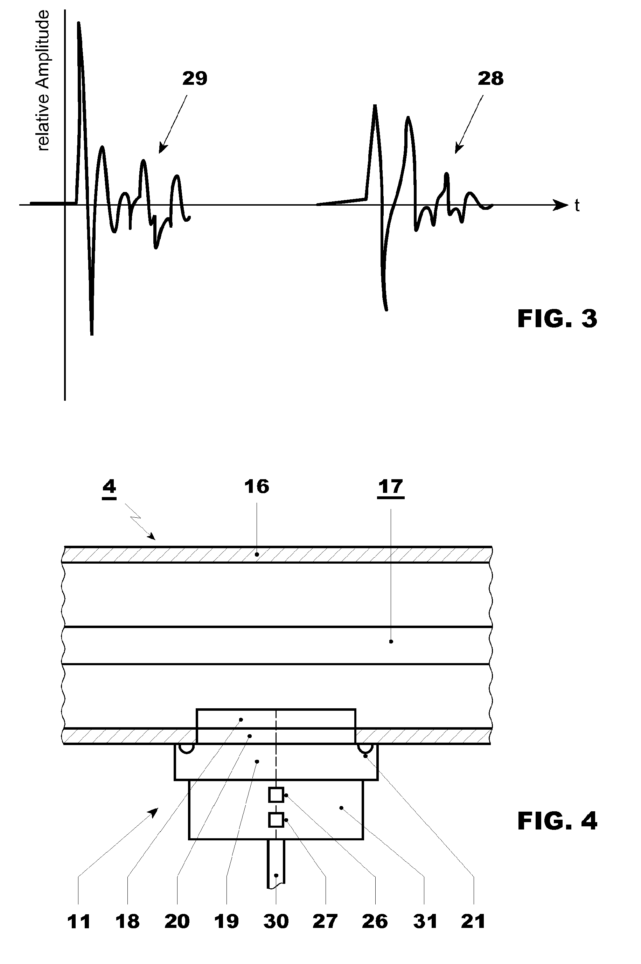

With reference to figure 4, bus ducts 4 are known to comprise an external earthed enclosure 16 (bus duct enclosure) containing an inner current-carrying conductor 17 (bus duct inner conductor).

In the simplest embodiment, the sensors 11 is an antenna 18 mounted to the inside face of a flange 19 to be connected to the bus duct enclosure 16 with the interposition of an insulating layer 20, in such a way that it exhibits its highest sensitivity in the direction of the interior of the bus duct enclosure 16 towards the bus duct conductor 17.

Furthermore the antenna 18 is connected via the coaxial cable 30 to the measuring instrument 12.

This allows the antenna 11 to be automatically shielded from external disturbances by the metallic enclosure 16 of the bus duct 4 and enhances the sensitivity of the antenna and its signal-to-noise performance.

The flange 19 may be fitted with a gasket 21 arranged to establish contact between the metallic enclosure 16 and the circumference of the flange 19 in order to provide further isolation of the antenna 18 from external electromagnetic signals and interference.

The gasket 21 is preferably made of conductive or semi-conductive material; for example it is made of a metal powder loaded elastomer or a continuous metallic (conducting) coil or conductive plastic foam or it may be in the form of a woven metallic mesh.

In different embodiments, the antenna 18 may take the form of a disc, a spiral, inverted cone, or radial lobe, depending on the frequency range and sensitivity desired.

In some different embodiments, all sensors 10, 11 may be connected to a multiplexer 25 and between each sensor 10, 11 and the multiplexer 25 the amplifier 26 and/or filter 27 may be provided.

The amplifier 26 and the filter 27 are preferably housed within an enclosure 31 mounted on the back of the flange 19, so that they are protected against external background radio frequency interference; in addition the amplifier 26 of and the filter 27 may be interchanged depending on the needs.

The measuring instrument 12 may be a part of the device 2 or a separate instrument.

In case the measuring instrument 12 is a part of the device 2 it comprises circuits arranged to compare the signals from the sensors 10 and 11 to determine the position of the defect originating the partial discharges.

In case the measurement instrument 12 is a separate instrument, it may be a spectrum analyzer, an oscilloscope, a device which detects and displays signals with reference to the phase of the applied power frequency test voltage waveform (e.g. sinewave of 50 or 60 Hz), or a combination of such devices.

The operation of the device is clear from that which is described and illustrated and is substantially the following.

If no defect is present in the rotating electric machine 3 and bus duct 4, no partial discharge signals are detected by the sensors 10, 11.

In case a defect is present (in the following reference to figure 1 and one single phase of the electric system is made) for example in position D, it generates pulses that generate partial discharge signals that propagate, reaching the sensor 11 and the sensor 10.

These signals are thus detected by the sensors 11, 10, amplified, filtered and then transmitted to the measuring instrument 12.

Figure 3 shows an example of the first signal 28 detected by the first sensor 10 and the second signal 29 detected by the second sensor 11.

Supposing that the time delay is measured by the measuring instrument 12, when the measuring instrument 12 indicates that the second signal 29 is received before the first signal 28 (i.e. the partial discharge signals reach the second sensor 11 before they reach the first sensor 10), the defect generating the partial discharges is closer to the second sensor 11 than to the first sensor 10 and therefore it is located in the bus duct 4.

However when the first signal 28 is detected before the second signal 29 (i.e. when the partial discharge signals reach the first sensor 10 before they reach the second sensor 11), then the defect generating the partial discharges can be located either in the rotating electric machine 3 or in the bus duct.

In this case:
- if the difference in arrival time between the first signal 28 and the second signal 29 is less than the time for the partial discharge signals to travel between the two sensors 10, 11, then the defect is within the zone between the two sensors 10, 11 (e.g. within the bus duct 4);
- if the difference in arrival time between the first signal 28 and the second signal 29 is greater than the time for the partial discharge signals to travel between the two sensors 10, 11, then the defect generating the partial discharges is located within the rotating electric machine 3.

In case the amplitudes of the signals are used for comparison the procedure is substantially the same; it is clear that the defect generating the partial discharges is closer to the sensor which indicates the higher relative amplitude.

Thus, in the case that the second signal 29 detected by the second sensor 11 has a greater relative amplitude than the first signal 28 detected by the first sensor 10, then the partial discharge signals originate closer to the sensor 11 than to the sensor 10, thus indicating that the defect is located in the bus duct 4.

In case the first signal 28 has a greater relative amplitude than the second signal 29 (i.e. the partial discharge signals originate closer to the sensor 10), the defect may be located in the rotating machine 3 or bust duct 4.

In this case if the difference in relative amplitude between the signals 28 and 29 is less than the amplitude decrease of the partial discharge signals (detectable by the sensors 10, 11) when traveling between the two sensors 10, 11, then the defect is within the zone between the two sensors, e.g. in the bus duct 4.

However if the first signal 28 has a greater relative amplitude than the second signal 29 (i.e. the partial discharge signals originate closer to the sensor 10) and the difference in relative amplitude between the signals 28 and 29 is greater than the amplitude decrease of the partial discharge signals (detectable by the sensor 10, 11) when traveling between the two sensors 10, 11, then the defect is located within the rotating electric machine 3.

The present invention also refers to a method for detecting the partial discharges generated in an electric system 1 comprising the rotating electric machine 3 and the bus duct 4.

The method comprises:
- detecting at least a first signal 28 indicative of the partial discharges at a first location of the electric system,
- detecting at least a second signal 29 indicative of the partial discharges at a second location of the electric system,
- comparing the signals 28, 29 to ascertain whether they originate from defects located within the rotating electric machine 3 or the bus duct 4.

Generally the first location is at the generator 3 and the second location is within the bus duct 4.

In different embodiments of the method, the time displacement of the first and second signals 28, 29 and/or the difference in relative amplitude between the first and second signals 28, 29 are compared.

Generally, before the first and second signals 28, 29 are compared, the difference in the lengths of the coaxial cables 30 connecting a sensor 10 measuring the first signal 28 and the measuring instrument 12 and a sensor 11 measuring the second signal 29 and the measuring instrument 12 is compensated for. This allows the time displacement or amplitude difference to be assessed independently of the differences in the lengths of the coaxial cables.

Preferably, the signals 28 and 29 for each phase of the electric system 1 are detected.

Additionally, a plurality of second signals 29 at a plurality of second locations along the same phase of the bus duct 4 may be detected.

Naturally the features described may be independently provided from one another.

In practice the materials used and the dimensions can be chosen at will according to requirements and to the state of the art.

### REFERENCE NUMBERS

- 1: electric system
- 2: device for detecting partial discharge in 1
- 3: rotating electric machine
- 4: bus duct
- 5: electric grid
- 6: transformer
- 10: sensor (typically a capacitive coupler)
- 11: sensor (bus duct partial discharge sensor)
- 12: measuring instrument
- 16: enclosure of 4
- 17: conductor of 4
- 18: antenna
- 19: flange
- 20: insulating layer
- 21: gasket
- 25: multiplexer
- 26: amplifier
- 27: filter
- 28: first signal
- 29: second signal
- 30: coaxial cable
- 31: enclosure of 11
- D: position of a defect

## Claims

1. Method for detecting the partial discharges generated in an electric system (1) that comprises a rotating electric machine (3) and a bus duct (4), the method comprising detecting at least a first signal (28) indicative of the partial discharges at a first location of the electric system (1), **characterised by** detecting at least a second signal (29) indicative of the partial discharges at a second location of the electric system (1), comparing the first and the second signals (28, 29) to ascertain whether a defect generating them is located within the rotating electric machine (3) or the bus duct (4).

2. Method as claimed in claim 1, **characterised in that** the first location is at the rotating electric machine (3).

3. Method as claimed in claim 2, **characterised in that** the first location is in a zone between the output of the rotating electric machine (3) and the end of the bus duct (4) connected thereto.

4. Method as claimed in claim 1, **characterised in that** the second location is at the bus duct (4).

5. Method as claimed in claim 1, **characterised in that** the time displacement between at least a first and at least a second signal (28, 29) is compared.

6. Method as claimed in claim 1, **characterised in that** the relative amplitude difference between at least a first and at least a second signal (28, 29) is compared.

7. Method as claimed in claim 1, **characterised by** compensating the difference in the lengths of the cables (30) connecting the sensors (10) measuring the first signal (28) and a measuring instrument (12), and the sensors (11) measuring the second signal (29) and the measuring instrument (12).

8. Method as claimed in claim 1, **characterised by** detecting at least a first signal (28) and at least a second signal (29) for each phase of the electric system (1).

9. Method as claimed in claim 4, **characterised by** detecting a plurality of second signals (29) at a plurality of second locations along the same phase of the bus duct (4).

10. Electric system (1) with a device (2) for detecting the partial discharges generated therein comprising a rotating electric machine (3) and a bus duct (4), wherein the device (2) comprises at least a first partial discharge sensor (10) arranged to detect first signals (28) indicative of the partial discharges and provided at a first location of the electric system (1), **characterised by** comprising at least a second partial discharge sensor (11) arranged to detect second signals (29) indicative of the partial discharges and connected at a second location of the electric system (1), a measuring instrument (12) connected to the first and second sensors (10, 11) and arranged to compare the first and second signals (28, 29) to ascertain whether a defect generating them is located within the rotating electric machine (3) or the bus duct (4).

11. Electric system (1) as claimed in claim 10, **characterised in that** the first location is at the rotating electric machine (3).

12. Electric system (1) as claimed in claim 11, **characterised in that** the first location is in a zone between the output of the rotating electric machine (3) and the end of the bus duct (4) connected thereto.

13. Electric system (1) as claimed in claim 10, **characterised in that** the second location is at the bus duct (4).

14. Electric system (1) as claimed in claim 10, **characterised by** comprising at least a first partial discharge sensor (10) and at least a second partial discharge sensor (11) for each phase of the electric system (1).

15. Electric system (1) as claimed in claim 10, **characterised by** comprising a plurality of second partial discharge sensors (11) at a plurality of second locations along the same phase of the bus duct (4).
